(19) Europäisches Patentamt
European Patent Office
Office européen des brevets

(11) **EP 1 943 734 B1**

(12) **EUROPÄISCHE PATENTSCHRIFT**

(45) Veröffentlichungstag und Bekanntmachung des Hinweises auf die Patenterteilung:
**10.02.2010   Patentblatt 2010/06**

(21) Anmeldenummer: **06818321.9**

(22) Anmeldetag: **30.10.2006**

(51) Int Cl.:
***H03K 17/955*** (2006.01)

(86) Internationale Anmeldenummer:
**PCT/EP2006/010430**

(87) Internationale Veröffentlichungsnummer:
**WO 2007/048640 (03.05.2007 Gazette 2007/18)**

(54) **SCHALTUNG ZUR ERFASSUNG DER PRÄSENZ, POSITION UND/ODER ANNÄHERUNG EINES OBJEKTES AN WENIGSTENS EINE ELEKTRODENEINRICHTUNG**

CIRCUIT FOR DETECTING THE PRESENCE, POSITION AND/OR APPROACH OF AN OBJECT IN RELATION TO AT LEAST ONE ELECTRODE DEVICE

CIRCUIT POUR DETERMINER LA PRESENCE, LA POSITION ET/OU L'APPROCHE D'UN OBJET AU NIVEAU D'AU MOINS UN DISPOSITIF A ELECTRODES

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **28.10.2005   DE 102005051834**
**06.06.2006   DE 102006026192**

(43) Veröffentlichungstag der Anmeldung:
**16.07.2008   Patentblatt 2008/29**

(73) Patentinhaber: **Ident Technology AG**
**82234 Wessling (DE)**

(72) Erfinder: **FASSHAUER, Peter**
**85579 Neubiberg (DE)**

(74) Vertreter: **Beck & Rössig**
**European Patent Attorneys**
**Cuvilliésstrasse 14**
**81679 München (DE)**

(56) Entgegenhaltungen:
**EP-A- 0 977 363      EP-A1- 0 029 673**
**EP-A1- 0 158 593      EP-A2- 0 398 728**
**US-A1- 3 103 655      US-A1- 3 798 551**
**US-A1- 6 081 185**

• **HARRISON A ET AL: "DUAL COMPARATORS STABILIZE PROXIMITY DETECTOR" EDN ELECTRICAL DESIGN NEWS, REED BUSINESS INFORMATION, HIGHLANDS RANCH, CO, US, Bd. 43, Nr. 4, 16. Februar 1998 (1998-02-16), Seiten 102-104, XP000778423 ISSN: 0012-7515**

**Beschreibung**

Die Erfindung richtet sich auf eine Schaltung gemäß dem Oberbegriff von Patentanspruch 1. Diese Schaltung dient der Bewerkstelligung der Erfassung der Präsenz, Position, und/oder des Eindringens eines Objektes, insbesondere von Gliedmaßen in einem bzw. in einen Observationsbereich.

Eine Schaltung der vorgenannten Art ist aus US 3,103,655 bekannt. Weiterhin sind Näherungs- oder Berührungssensoren bekannt, bei welchen eine Präsenzerfassung auf Grundlage feldelektrischer Wechselwirkungseffekte durchgeführt wird. Maßgeblich ist hierbei eine elektrische Eigenschaft des menschlichen Körpers, die darin besteht, dass der leitende Körper in der Nähe einer Signalelektrode, an der eine Spannung gegenüber Erdpotential anliegt, das hiervon ausgehende elektrische Feld beeinflusst. Eine quantitative Beschreibung dieses Effektes erfolgt durch Kapazitäten, da der Körper aufgrund seiner Leitfähigkeit ein eingekoppeltes Feld vom Körper weg abstrahlt, wodurch er gegen Erde eine erhebliche Kapazität von typischerweise ca. 120pF bis 150pF bildet. Hierdurch verändert der Körper durch Annäherung oder Berührung die Kapazität einer Signalelektrode. Die Kapazität der Signalelektrode ist bei bekannten Erfassungssystemen häufig frequenzbestimmend. Durch Frequenzmessung kann die Annäherung detektiert werden.

Ein Problem hierbei ist die für bestimmte Anwendungen erforderliche Empfindlichkeit und Störfestigkeit des Verfahrens. Bei der Detektion kleinster Körperteile, wie z.B. eines Fingers ergeben sich häufig nur geringe Kapazitätsänderungen von 0,01 bis 0,1 pF, die noch erkannt werden müssen. Die erreichbare Empfindlichkeit wird dabei durch die relative Kapazitätsänderung gegenüber der Grundkapazität eines Oszillators bestimmt, die daher möglichst klein sein sollte, was wiederum eine hohe Schwingfrequenz bedeutet, die einmal hinsichtlich der EMV Problematik und außerdem gegen von außen einwirkende Störspannungen kritisch sein kann.

Der Erfindung liegt die Aufgabe zugrunde, eine schaltung zu schaffen die es ermöglicht, die Näherung eines Objektes, insbesondere eines belebten Körpers, an eine Sensorelektrode in einer gegenüber bisherigen Ansätzen empfindlicheren und gleichzeitig sichereren Weise zu ermöglichen.

Diese Aufgabe wird erfindungsgemäß durch eine schaltung mit den in Patentanspruch 1 angegebenen Merkmalen gelöst.

Diese Schaltung ermöglicht es, eine Annäherung eines Objektes an die Sensorelektrode mit hoher Genauigkeit und Zuverlässigkeit festzustellen.

Diese Austungsschaltung ist derart konfiguriert und aufgebaut, dass diese eine Annäherung eines Objektes an die Sensorelektrodeneinrichtung anhand einer Änderung des Resonanzverhaltens detektiert. Als Änderung des Resonanzverhaltens wird erfindungsgemäß die Veränderung der Phasenlage eines Vergleichssignals aus dem LC-Netzwerk gegenüber einem Vergleichssignal aus dem Bereich des Generators erfasst. Das aus dem Bereich des Generators abgegriffene Signal kann die Generatorspannung oder insbesondere auch ein Generatortriggersignal sein.

Die Erfindung ermöglicht die Realisierung eines Positionserfassungssystems über welches Abstandsinformationen gewonnen werden können.

Durch die Änderung der dielektrischen Eigenschaften in der Umgebung der Sensorelektrode wird das Resonanzverhalten der beiden LC-Netzwerke zueinander beinflusst. Dieses kann anhand einer Änderung der Phasenlage der entsprechenden Signale zueinander bewertet werden.

Es ist möglich, die Erregerfrequenz zu variieren. Die Veränderung der Erregerfrequenz kann in Abhängigkeit von der Phasenlage erfolgen. Der Änderungsbedarf der Erregerfrequenz kann hierbei als Präsenzsignal ausgewertet werden.

Gemäß einem besonderen Aspekt der vorliegenden Erfindung ist es möglich, systematische Änderungen der Kapazität eines unter Einschluss der Sensorelektrode gebildeten Kondensatorsystems definiert zu kompensieren. Derartige systematische Änderungen können beispielsweise auftreten, wenn die Sensorelektroden im Zusammenspiel mit Bewegtsystemen (z.B. Fensterhebern, Schiebedächern, Verdeckanordnungen, Sitzstellsystemen, Türen, Klappen, insbesondere Kofferraumdeckeln) Anwendung finden. Zweck derartiger Elektroden kann dabei die Detektion von Gliedmaßen in verletzungsrelevanten Zonen sein. Die systematischen Änderungen der Kapazität des Sensorelektroden-Kondensatorsystems können dabei berücksichtigt werden, indem in jenem die Sensorelektrode umfassenden LC-Netzwerk Kompensationsvorgänge abgewickelt werden. Diese Kompensationsvorgänge können insbesondere über Schaltungsabschnitte mit einem Varactordiodensystem, und/oder einem Gyratorsystem abgewickelt werden. Durch diese Ansätze wird es möglich, auch bei stellvorgangsbedingten Änderungen der Kapazität des unter Einschluss der Sensorelektrode gebildeten Kondensatorsystems das System im Bereich einer Parallelresonanzfrequenz zu betreiben und damit Ereignisdetektionen bei im wesentlichen gleichbleibender Detektionsfrequenz durch Phasenverschiebungseffekte zu detektieren.

Gemäß einem besonderen Aspekt der Erfindung ist es möglich, über die genannten Kompensationsschaltungen (z.B. Varactor-Diode, sowie Gyrator) das System permanent im Bereich einer vorteilhaften Systemfrequenz zu betreiben. Als Detektionsereignis kann dann der Nachstellbedarf am Gyrator- oder Varaktordiodensystem interpretiert werden. Insbesondere kann ein Detektionsereignis erkannt werden, wenn der Nachstimmungsbedarf des Ausgleichssystems eine andere Dynamik aufweist , als diese durch die Dynamik eines momentan ablaufenden Stellvorgangs begründet ist. Ein Störereignis, oder eine Objektnäherung kann dann erkannt werden, wenn die Ableitung des Nachstellbedarfs am Kompensationssystem um einen bestimmten (ggf, nach einer Funktion variierenden) Betrag von einer Ableitung abweicht die sich hinsichtlich des Nachstellbedarfs des Kompensationssystem bei ordnungsgemäßem Stellvorgang ergibt.

Es ist möglich, über den Nachstellbedarf des Kompensationssystems auch den Näherungszustand eines Objektes Sensor an die Elektrodeneinrichtung zu detektieren. Der Schaltungsansatz kann hierbei derart gewählt sein, dass das LC-Netwerk stets bei Parallelresonanz, oder mit einem bestimmte Phasenversatz des Erregungsereignisses gegenüber der Resonanzschwingung betrieben wird, und auf der Seite des Resonanzsystems eine Nachstellung zur Beibehaltung des Phasenversatzes (oder zur Realisierung eines definierten Versatzzustandes) vorgenommen wird. Dieser Nachstellbedarf kann als Auswertungsgrundlage für die Angabe des momentanen Näherungszustandes verwendet werden.

In vorteilhafter Weise erfolgt insoweit eine Nachführung der Generatorfrequenz zur Anpassung an sich ändernde Kapazitäten, die z.B. bei bewegten Objekten wie Fenstern oder Schiebedächern auftreten können. Die dynamische Anpassung der Sensorkennlinie an die Bewegung unter Beibehaltung der Phasensteilheit des Sensors hat den Vorteil, dass während eines Bewegungs- oder Stellvorganges die Detektionsempfindlichkeit des Systems aufrecht erhalten bleibt.

Vorzugsweise erfolgt eine Erhöhung des die Sensorempfindlichkeit bestimmenden Gütefaktors des Schwingkreises durch gleichphasige Rückkopplung mittels einer Kapazität auf den Schwingkreis, wodurch dieser entdämpft wird und dadurch die Güte bzw. die Sensitivität des Sensors steigt.

Eine gleichphasige Rückkopplung ergibt sich automatisch auch durch Verwendung einer Abschirmung (Shield) der am Resonanzkreis angeschlossenen Elektrode gegenüber einem Bezugspotential wie z.B. Erde oder bei Fahrzeugen dem Chassis, wenn diese Abschirmung gleichphasig angekoppelt wird. Infolge einer kapazitiven Kopplung zwischen Elektrode und Shield ergibt sich dann ein Rückkopplungseffekt , der bei geeigneter Dimensionierung der Anordnung zu einer Entdämpfung des Resonanzkreises und damit vorteilhaft zu einer Erhöhung der Sensorempfindlichkeit führt.

Erfindungsgemäß wird, die Spule als Induktivität durch einen Gyrator ersetzt, mit der beispielsweise eine Kapazität in eine Induktivität transformiert wird.

Es ist möglich, die erfindungsgemäße Schaltung zur Bereitstellung des LC-Netzwerkes in unmittelbarer Nachbarschaft der durch die Sensorelektrode zu observierenden Zone anzuordnen, so dass auf aufwendige, ggf. abgeschirmte Verbindungsleitung zwischen der Sensorelektrode und dem angekoppelten LC-Netwerk verzichtet werden kann.

Als Detektionsgrundlage kann dann beispielsweise lediglich die Information exportiert werden, mit welcher Frequenz das System läuft, und welche Kapazität, und/oder Induktivität im angekoppelten, auf die Parallelresonanzfrequenz abgestimmten LC-Netwerk momentan eingestellt ist. Abweichungen der Dynamik der Nachstellung von einer stellvorgangsbedingten Dynamiken der Nachstellung kann als Detektionsereignis, das Nachstellungsausmaß als Information über die tatsächliche Annäherung interpretiert werden.

Die Nachführung kann durch Adaption der Generatorfrequenz und/oder Adaption der Eigenschaften des Resonanzschaltkreises erfolgen. Vorzugsweise ist die Änderung so abgestimmt, dass die systematischen, also z.B. stellvorgangsbedingten Änderungen kompensiert werden.

Weitere Einzelheiten und Merkmale der Erfindung ergeben sich aus der nachfolgenden Beschreibung in Verbindung mit der Zeichnung. Es zeigt:

**Fig.1a**    eine Schaltungsskizze zur Erläuterung des Grundauf- baus eines Kapazitiv-Näherungssensorsystems;

**Fig.1b**    eine Schaltungsskizze zur Erläuterung der elektri- schen Verhältnisse des Systems nach Figur 1 bei Präsenz eines Objektes im Observationsbereich;

**Fig.2a**    eine Schaltungsskizze zur Erläuterung des Grundauf- baus eines Kapazitiv-Näherungssensorsystems mit einem Sensorsystem, das ein LC-Netzwerk umfasst, wel- ches mit der Sensorelektrode gekoppelt ist.

**Fig.2b**    ein Sensorsystem mit Rückkopplung zur Erhöhung der Empfindlichkeit.

**Fig.3**    ein Sensorsystem mit Rückkopplung infolge einer gleichphasigen Ansteuerung eines Shields zur Ab- schirmung der Elektrode

**Fig.4**    ein Diagramm zur Veranschaulichung der Phasenände- rung bei Variation der Kapazität

**Fig.5**    eine Blockschaltbild zur Erläuterung der Einbindung der Grundschaltung nach Figur 2a in eine Auswer- tungsschaltung;

Fig.6    eine Elektrodenanordnung zur X- und Y Koordinatener- fassung gemäß dem Phasenverfahren

Fig.7    ein Diagramm zur Veranschaulichung einer Lineari- sierung der Phasenabhängigkeit von der Positionsko- ordinate x.

Fig.8    eine Elektrodenstruktur als Gitter zur Verbesserung der Genauigkeit einer Positionsbestimmung bei großen Flächen

Fig.9    ein Blockschaltbild zur Erläuterung eines Mehrkanal- detektionssystems ,bei welchem eine Feststellung des Näherungszustandes an mehreren Sensorelektroden durch sukzessive Bestimmung der Phasenlagen am LC- Netzwerk gegenüber dem Generatorsignal erfolgt.

Fig.10   eine Skizze zur Illustration der Einsatzmöglichkeit einer erfindungsgemäßen Schaltungseinrichtung bei einer Fensterhebereinrichtung zur Kompensation stellvorgangsbedingter, d.h. durch den Scheibenhub verursachter systematischer und zulässiger Änderun- gen der Kapazität eines unter Einschluss einer Sen- sorelektrode (Strichpunktlinie) gebildeten LC- Sensorsystems.

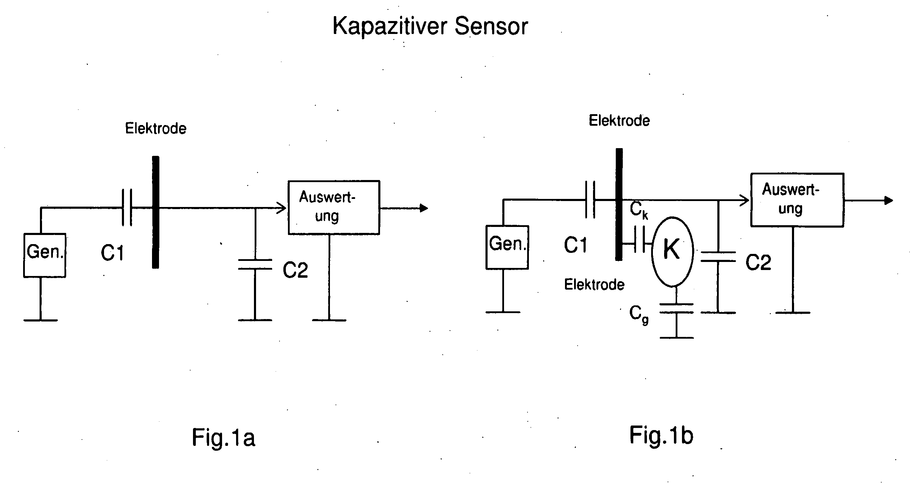

Ein Konzept, die Annäherung eines Körpers an eine Sensorelektrode zu erfassen besteht darin, einen Signalgenerator über einen Kondensator C1 an eine Elektrode anzuschließen, die gleichzeitig mit einer Auswerteeinheit verbunden ist (Fig.1a). Hierdurch entsteht infolge einer Eingangskapazität C2 der Auswerteeinheit ein kapazitiver Spannungsteiler,der eine vom Generator gelieferte Spannung am Eingang der Auswerteelektronik um den Faktor

$$k= C1/\ C1+C2 \qquad (1)$$

abschwächt. Bei z.B. C1 = 1pF und C2=10 pF werden ca. 9% der Generatorspannung am Eingang der Auswerteeinheit empfangen.

Nähert sich nun ein Körperteil K der Empfangselektrode, wie in Fig. 1b dargestellt, erhöht sich über die Körperkopplungskapazität Ck und die Groundkapazität Cg des Körpers die Eingangskapazität C2 auf einen größeren Wert C2*= C1+Ck, da stets Cg » Ck anzunehmen ist. Der Spannungsteilerfaktor beträgt damit

$$k*= C1/C1+C2+Ck \qquad (2)$$

Für eine Kopplungskapazität des Körpers von z.B. Ck=0, 1pF ändert sich daher die Empfangsspannung um ca. 1%. Die Empfindlichkeit der Anordnung ist relativ gering.

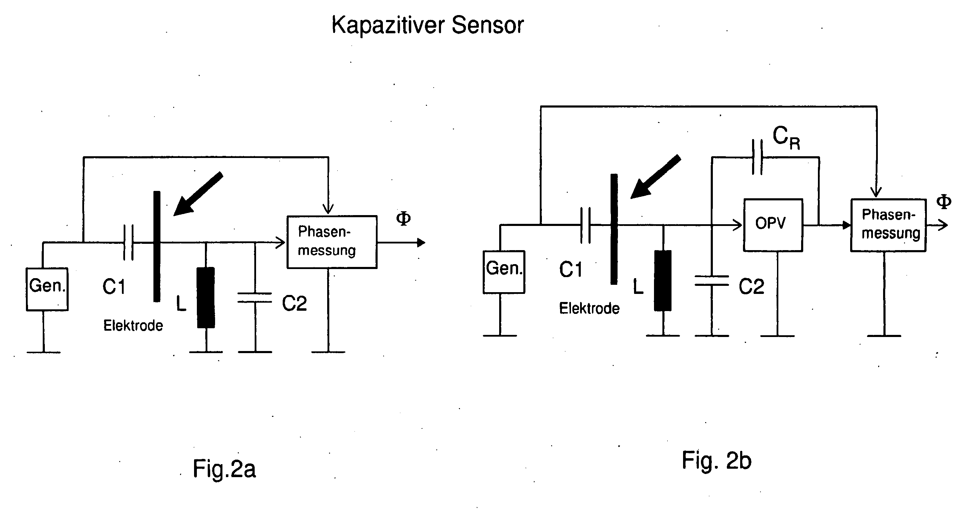

Die Empfindlichkeit wird um ein Vielfaches erhöht, indem am Eingang der Auswerteelektronik ein LC-Netzwerk angeordnet ist. Dieses besteht im einfachsten Fall aus einem Kondensator, zu welchem eine Induktivität L parallel geschaltet wird, wodurch die in Fig.2a dargestellte Resonanzschaltung entsteht. Bei Abstimmung der Generatorfrequenz auf die Resonanzfrequenz dieses Netzwerkes entsteht infolge Resonanzüberhöhung am Auswerteeingang eine Spannung, die sogar größer sein kann, als die Generatorspannung, so dass diese auf wesentlich niedrigere Werte eingestellt werden kann als im Fall der Anordnung nach Fig.1.

Der wesentliche Vorteil der Anordnung nach Figur 2a liegt einmal darin, dass die Empfindlichkeit gegenüber Kapazitätsänderungen durch den Körper um ein Vielfaches gegenüber bisherigen Verfahren gesteigert werden kann, indem ein Resonanzkreis infolge der Kapazitätsänderung aus der ursprünglich eingestellten Resonanz verstimmt wird und es hierdurch zu einer Amplituden- und Phasenänderung bezüglich des eingespeisten Generatorsignales kommt. Beide Signalparameter können zur Indikation einer Körpernäherung verwendet werden. Am vorteilhaftesten wird jedoch die Phasenlage ausgenutzt, da man damit weitgehend unabhängig von irgendwelchen Amplitudenänderungen auf der Generatorseite bleibt und außerdem hiermit eine noch größere Empfindlichkeit hinsichtlich Kapazitätsänderungen erreicht. Ferner kann bei Anwendung des Phasenverfahrens die Spannung am Resonanzkreis niedrig gehalten werden, was sich vorteilhaft auf die Feldemission an der Signalelektrode auswirkt und damit die EMV-Problematik bezüglich der Strahlungsemission vermindert.

Weiterhin ist ein Phasenverfahren prinzipiell auch unempfindlicher gegen von außen einwirkenden Störungen auf der Empfangsseite als ein Amplitudenverfahren. Hinzu kommt für den Fall der Störungen, dass mit dem Verfahren durch den schmalbandigen Resonanzkreis eine Filterung erfolgt und außerdem durch Wahl einer hohen Empfangsspannung der Störeinfluss weiter vermindert werden kann. Vorteilhaft ist es auch, für die Messung der Phasenverschiebung ein einfaches rein digitales Verfahren zu verwenden, wie nachfolgend noch ausgeführt werden wird. Aus den dargelegten Gründen wird daher das Phasenverfahren bevorzugt und im weiteren näher beschrieben.

Die in Fig. 2a dargestellte Struktur umfasst zur erleichterten Veranschaulichung des erfindungsgemäßen Konzeptes eine Basisvariante eines LC-Netzwerkes. Für diese Struktur erhält man aus der Theorie (z.B. in [1]) die Phasenverschiebung $\Phi$ zwischen dem Generatorsignal mit der Frequenz f und dem Empfangssignal aus

$$\Phi(f)= \text{arctan } [\ 1/Q\ (f/f_0)/(f/f_0)^2-1]\qquad(3)$$

worin Q der Gütefaktor des Kreises und $f_0$ die Resonanzfrequenz ist.

Für die Phasensteilheit im Resonanzpunkt ergibt sich dann

$$d\Phi/df\ =\ -\ 2Q/f_0\qquad(4)$$

Aus Gl.3 ist ersichtlich, dass bei Resonanz die Phasenverschiebung 90° beträgt.

Die Änderung der Phase in der Nähe der Resonanzfrequenz ist nach Gl.4 umso größer, je höher der Gütefaktor Q ist. Hierin liegt die hohe Empfindlichkeit des Sensors begründet. Bei einer relativen Änderung der Kapazität von $\Delta C/C$ mit C=C1+C2 ist die Phasenänderung

$$\Delta\phi =(\Delta C/C)Q\qquad(5)$$

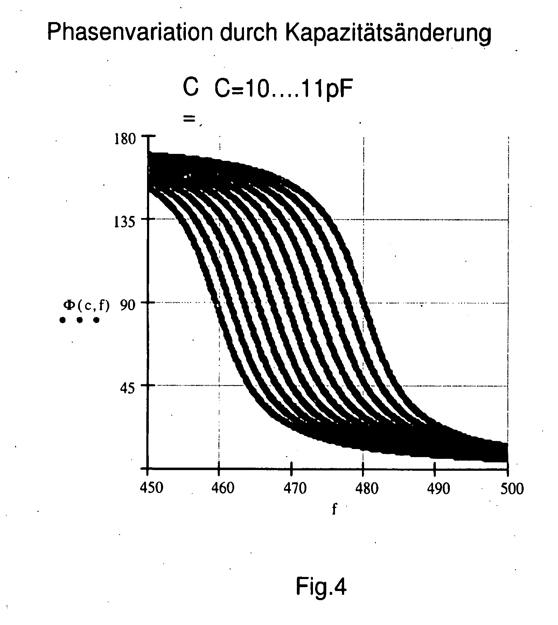

Die Empfindlichkeit des Sensors ist nach Gl.5 proportional zum Gütefaktor Q und kann damit durch Wahl eines hohen Wertes gegenüber bisher bekannten Verfahren entscheidend gesteigert werden. Für ein Beispiel mit C1=1pF, C2=10...11pF, L=10mH und Q=50 zeigt Fig 4 die Variation der Phasenverschiebung abhängig von der eingespeisten Frequenz und der Kapazitätsänderung als Scharparameter. Bei einer Resonanzfrequenz von 480kHz und einer Kapazitätserhöhung von 0,1 pF erhält man bereits eine Phasenverschiebung von 24°. Dies entspricht einer Änderung von 27% bezogen auf die Grundphase von 90°. Die gleiche Änderung würde im Fall der Anordnung von Fig.1 lediglich einen Wert von ca.1% ergeben.

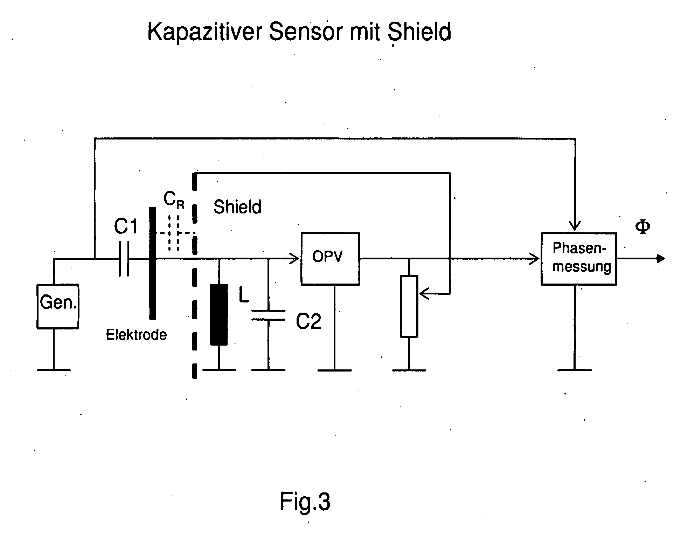

Der für die Sensorempfindlichkeit maßgebliche Gütefaktor, der hauptsächlich vom Verlustwiderstand der Spule bestimmt wird, lässt sich dadurch erhöhen, dass entsprechend Fig.2b die am Resonanzkreis anliegende Spannung über einen Operationsverstärker und einen Rückkopplungskondensator $C_R$ gleichphasig zurückgekoppelt wird, wodurch der Kreis entdämpft wird und dadurch die Güte steigt. Ein gleicher Effekt lässt sich bei Verwendung eines Shields (Fig. 3) zur Abschirmung der Sensorelektrode gegen Masseflächen erreichen, da dann zwischen Elektrode und Shield eine kapazitive Kopplung auftritt.

Auswerteelektronik

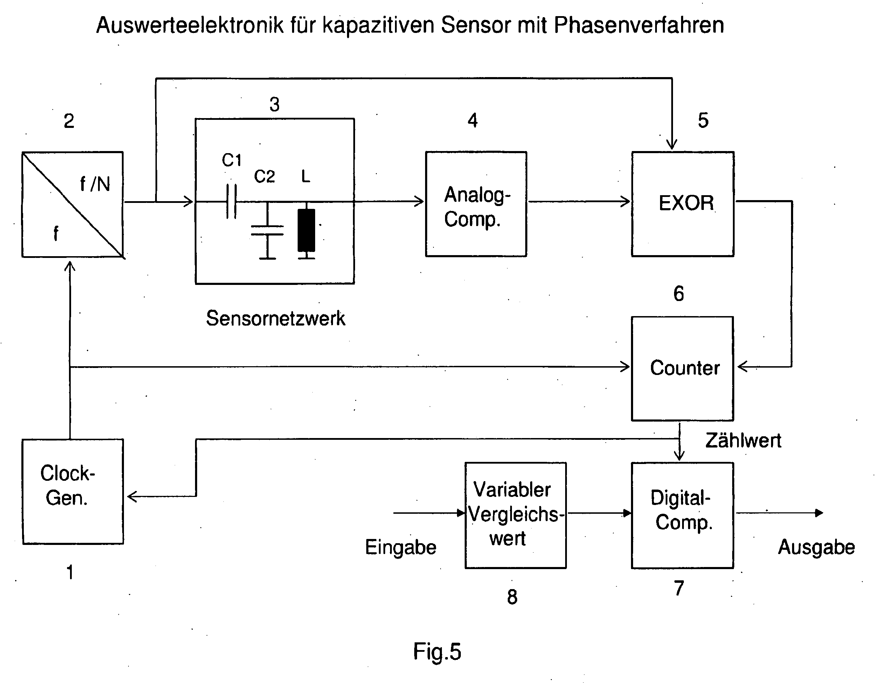

Nachfolgend wird eine elektronische Anordnung näher beschrieben, die zur Auswertung der Phasenverschiebung vorteilhaft verwendet werden kann (Fig.5 ). Ein Clockgenerator 1 erzeugt einen Takt von typischerweise 50...100 MHz, der in einem nachfolgenden Frequenzteiler 2 mit einer ganzen Zahl N so heruntergeteilt wird, dass die dem Netzwerk 3 von Fig. 2 entsprechende Resonanzfrequenz entsteht.

Im Beispiel von Fig. 5 beträgt der Teilerfaktor bei einer Clockfrequenz von 50 MHz und einer Resonanzfrequenz von 480 kHz dann N= 104.

Das Ausgangssignal dieses Netzwerkes mit einer im vorigen Abschnitt beschriebenen Grund-Phasenverschiebung von 90 ° wird einem Comparator 4 zugeführt und nachfolgend mit dem in Teiler 2 erzeugten Signal mittels einer EXOR-Funktion verknüpft, was mathematisch einer Multiplikation der beiden Signale entspricht. Hierdurch entsteht am EXOR-Ausgang ein digitales Signal mit einer Frequenz gleich der doppelten Resonanzfrequenz des Kreises und einer Impulsbreite, die direkt proportional zur Phasenverschiebung des Sensornetzwerkes 3 ist. Bei Auswertung dieser Impulsbreite mittels eines nachfolgenden Counters 6, der das Clocksignal während der Impulsdauer auszählt , ist das Zählergebnis ein Abbild der vom Sensornetzwerk erzeugten Phasenverschiebung. Der vom Counter gelieferte Zählwert kann dann über einen digitalen Comparator 7 mit einem in 8 eingelesenen Wert verglichen werden und somit ein Indikationssignal ausgeben, das einer bestimmten Phasenänderung bzw. einem Annäherungszustand des Körpers entspricht .Eine andere Möglichkeit der Auswertung besteht darin, das Ausgangssignal des EXOR-Gatters über einen Tiefpass zu filtern,wodurch eine zur Phasenverschiebung proportionale Gleichspannung entsteht, die mittels eines AD-Wandlers und eines Mikrocontrollers dann ausgewertet werden kann.

Um Langzeitdriften des Clockgenerators oder im Netzwerk zu kompensieren, besteht die Möglichkeit, mittels des Zählwertes oder der gewonnenen Gleichspannung den Clockgenerator in seiner Frequenz so nachzuregeln, dass sich im Ruhezustand stets eine Ausgangs-Phasenverschiebung von 90° am Sensornetzwerk einstellt. Die Körpernäherung wird dann lediglich als Änderung des Zählwertes erfasst, womit sich eine differenzierende Funktion dieser Auswertung ergibt.

Vorteil der Erfindung und Anwendung

Der große Vorteil der erläuterten Anordnung von Fig 5 ist es, die gesamte Auswerteelektronik mittels eines einzigen Mikrocontrollers in Verbindung mit nur einer entsprechend der Resonanz gewählten Induktivität zu realisieren um somit einen sehr empfindlichen Näherungssensor auf äußerst einfache platzsparende und kostengünstige Weise zu erhalten.

Eine typische Applikation ist z. B. der Einbau dieses Sensors in den Griff einer Autotür in Verbindung mit einer keyless access Funktion, wobei die Netzwerkkapazitäten C1 und C2 durch entsprechende Elektrodenanordnungen im Griff gebildet werden. Weiterhin ermöglicht das erfindungsgemäße Konzept auch die Realisierung von Sensoren zur Überwachung von Gefährungsbereichen, z.B. Bewegtspalten an Fenster-, Verdeck- Tür-, oder Kofferaumdeckelsystemen. Die Elektrodeneinrichtungen können flächig oder auch drahtartig ausgebildet sein. Sie können auch durch elektrisch hinreichende Komponenten realisiert sein, die als solche weiterer Funktionen haben (z.B. Türgriff).

Die Elektrodeneinrichtungen können auch als Schnittstellenelektroden für weitergehenden Signaltransfer herangezogen werden. Das an den Elektroden anliegende Signal kann z.B. dazu verwendet werden, dieses Signal über den Körper zu einer Empfangseinrichtung zu übertragen, um zu detektieren, ob sich der Körper an einer bestimmten Position befindet, die durch den Ort des Empfängers gekennzeichnet ist. Hierdurch können weitere Funktionen, wie z. B. eine Sitzbelegung in einem Automobil detektiert werden.

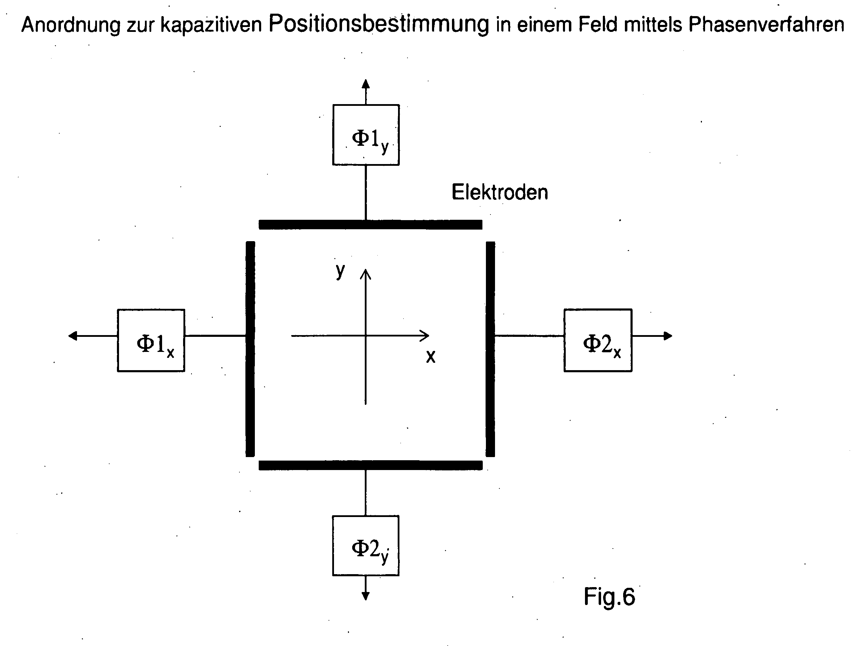

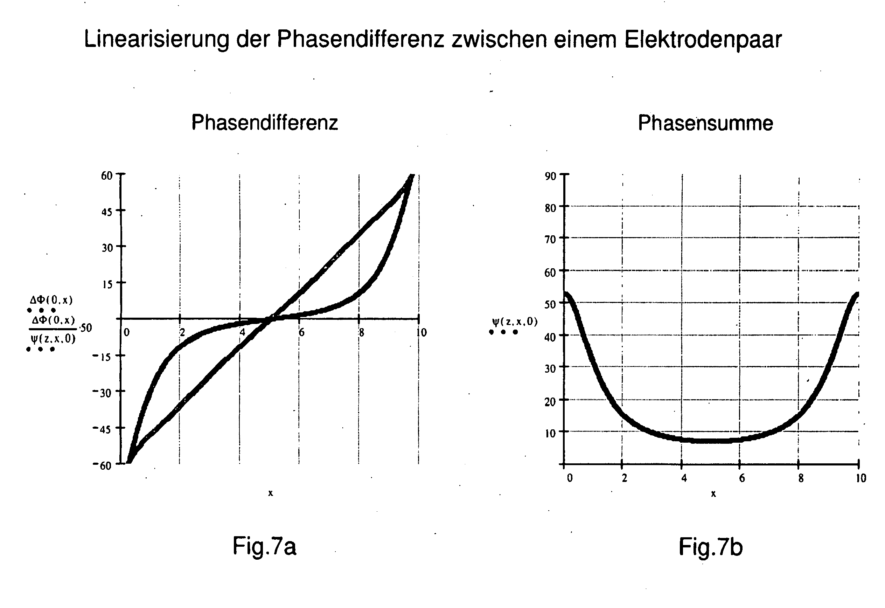

In Figur 6 ist ein Schema eines Positionserfassungssystems dargestellt, mit dem insbesondere eine Touchpad-artige Eingabefläche realisiert werden kann. Dabei wird der Näherungszustand an die jeweiligen X- und Y- Elektroden anhand,einer Auswertung der Phasenlagen $\Phi x$ und $\Phi y$ ermittelt, um die Position eines Fingers z.B. auf der Eingabefläche bei Haushaltsgeräten zu bestimmen und damit virtuelle Tasten zu aktivieren oder auch Zeigefunktionen an Bildschirmen im Rahmen sogenannter Gestik-Systeme zu ermöglichen. Hierzu ist die Bestimmung der x und y-Koordinaten auf der jeweiligen Fläche erforderlich. Dazu wird vorteilhaft jeweils die Phasendifferenz $\Delta\Phi = \Phi1-\Phi2$ und die Phasensumme $\Sigma\Phi = C1+<\Phi2$ der x und y Elektrodenpaare gebildet, wodurch eine Linearisierung der Koordinatenbestimmung möglich ist, wie in Fig. 7 am Beispiel der x-Koordinate gezeigt wird. Zunächst ergibt sich bei der Differenzbildung im allgemeinen ein nichtlinearer Verlauf in Abhängigkeit von x (Fig.7a), der insbesondere in der Mitte des Feldes zu einer relativ starken Abflachung führt. Definiert man eine neue Funktion $\Psi = \Sigma\Phi-\Phi0$ (Fig.7b) und bildet

$$\Delta\Phi/\Psi = \Phi1-\Phi2/\Phi1+\Phi2-\Phi0 \quad (6)$$

mit einer geeignet gewählten Konstanten $\Phi0$, so ergibt sich die in Fig.7a dargestellte Linearisierung, die dann wegen der annähernden Proportionalität zur Koordinate zu einer einfachen Positionsbestimmung führt.

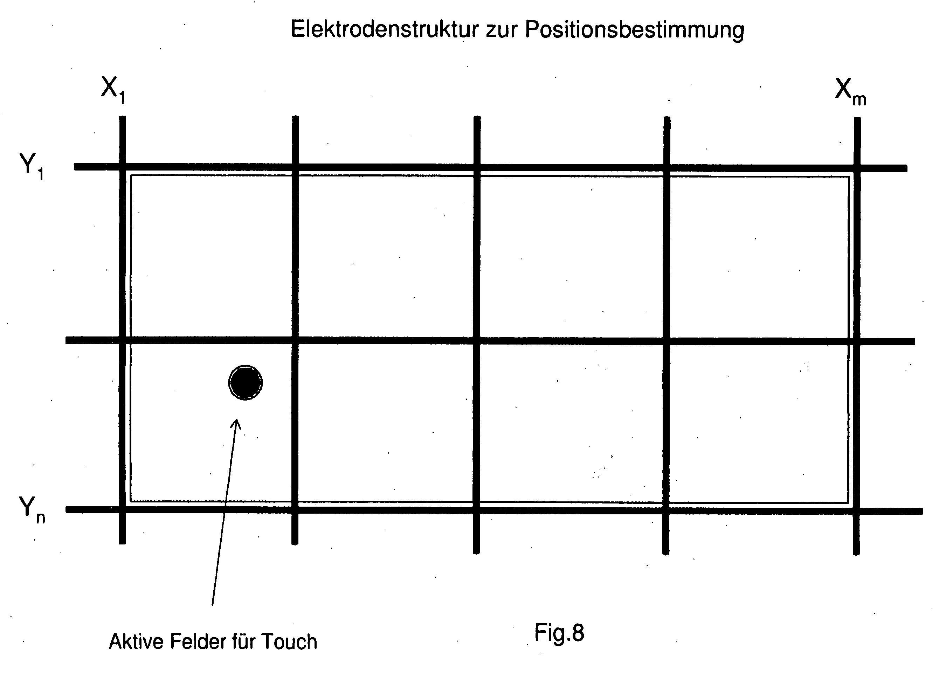

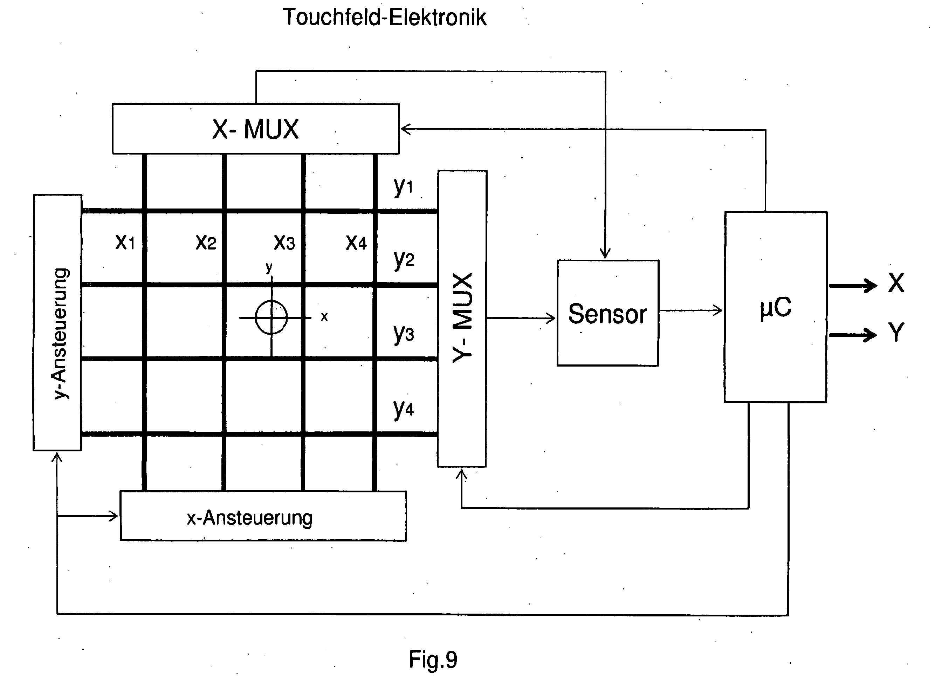

Um die Positionserfassung auf großen Flächen mit hinreichender Genauigkeit zu ermöglichen, ist die Anordnung mehrerer Elektroden z.B. in einer gitterförmigen Struktur erforderlich, wie Fig.8 zeigt. Die Auswertung der zugehörigen Phaseninformationen der Elektroden erfolgt dann zweckmäßigerweise mittels eines Multiplexers entsprechend dem Blockschaltbild von Fig.9, wodurch der Aufwand gering gehalten wird, da für alle Elektroden nur ein einziger Phasenmesser erforderlich ist. Die Positionsbestimmung innerhalb der einzelnen Felder des Gitters erfolgt nach dem gleichen oben beschriebenen Algorithmus.

Es ist möglich, synchron zur Abfrage der einzelnen Elektroden auch die Generatorfrequenz zu variieren, so dass hierdurch bestimmten Basiskapazitäten der einzelnen Systeme vorab Rechnung getragen werden kann.

Die Generatorfrequenz kann weiterhin auch im Rahmen eines Kalibrierzyklus auf die jeweiligen Systeme abgestimmt sein, so dass diese im Bereich der Parallelresonanz betrieben werden.

Die erfindungsgemäße Schaltung eignet sich in besonders vorteilhafter Weise auch zur Absicherung von Klemmspalten an Bewegtsystemen, insbesondere im Automotive-Bereich zur Absicherung von Verdecksystemen, Fenstern, Türen und Klappen.

Die entsprechenden Elektroden können in den näheren Bereich der klemmrelevanten Kanten integriert werden. Die Elektroden können in Funktionsteile, insbesondere Hebel, Bügel oder Rahmen integriert werden. Sie können in beliebigen Formen als dünne Film- oder leitfähige Lackstrukturen ausgeführt sein, die beispielsweise isoliert auf die Karosserie aufgebracht und anschließend überlackiert werden.

Zusammengefasst ergeben sich mit der erfindungsgemäßen Anordnung insbesondere folgende Vorteile gegenüber bisherigen Näherungssensoren:

1. Wesentlich erhöhte Empfindlichkeit hinsichtlich Kapazitätsänderungen durch Annäherung
2. Reduzierung der Störanfälligkeit durch große Empfangsamplituden und Selektion durch einen schmalbandigen Resonanzkreis
3. Unabhängigkeit von Amplitudenschwankungen durch Auswertung der Phasenverschiebung
4. Einfache Auswerteelektronik mit nur wenigen Komponenten
5. Auswertung durch rein digitale Verarbeitung mit der Möglichkeit zur Implementierung in einem Mikrocontroller oder ASIC
6. Dadurch platzsparende und kostengünstige Realisierung

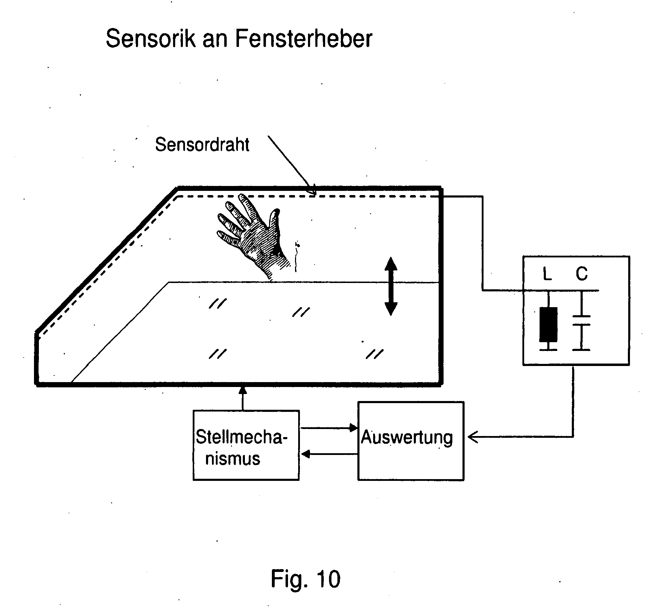

Figur 10 zeigt eine Skizze zur Illustration der Einsatzmöglichkeit einer erfindungsgemäßen Schaltungseinrichtung bei einer Fensterhebereinrichtung zur Kompensation stellvorgangsbedingter, d.h. durch den Scheibenhub verursachter systematischer und zulässiger Änderungen der Kapazität eines unter Einschluss einer Sensorelektrode (Strichpunktlinie) gebildeten LC-Sensorsystems. Es ist möglich, die Dynamik des zur Beibehaltung einer bestimmten Phasenlage des Generatorsignals mit der Schwingung im Parallelresonanzkreis erforderlichen Nachführung mit der durch einen Fensterhubmechanismus bereitgestellten Weg- oder Geschwindigkeitsinformation zu korrelieren. Ergeben sich hinsichtlich des Nachstellbedarfs Änderungsanforderungen mit höherer Dynamik, so sind diese auf äußere Einflüsse -z.B. wie hier dargestellt auf die Annäherung einer Hand zurückzuführen.

**Patentansprüche**

1. Schaltung zur Erfassung der Präsenz, Position und/oder Annäherung eines Objektes in einem Observationsbereich, mit:

   - einer Sensorelektrodeneinrichtung die Teil eines Kondensatorsystems bildet, dessen Kapazität gegen ein Referenzpotential von der Präsenz, Position oder Annäherung von Objekten in dem Observationsbereich abhängig ist,
   - einem LC-Netzwerk das jenes Kondensatorsystem umfasst,
   - einer mit der Sensorelektrodeneinrichtung gekoppelten Auswertungsschal - tung, und
   - einer Generatoreinrichtung zur Beaufschlagung des unter Einschluss der Sensorelektrodeneinrichtung und des LC-Netzwerkes gebildeten Systems mit einer Frequenz im Bereich einer Parallelresonanzfrequenz des LC-Netzwerkes, wobei

   die Auswertungsschaltung derart konfiguriert und aufgebaut ist, dass diese eine Annäherung eines Objektes an die Sensorelektrodeneinrichtung anhand einer Änderung des Resonanzverhaltens detektiert, und

   - wobei als Änderung des Resonanzverhaltens die Veränderung der Phasenlage eines Vergleichsignals des LC-Netzwerkes gegenüber einem Vergleichs - signal aus dem Bereich des Generators erfasst wird,

   **dadurch gekennzeichnet dass**

   - die am LC-Netzwerk anliegende Spannung über einen Operationsverstärker (OPV) und einen Rückkoppelungskondensator ($C_R$) gleichphasig zurückgekoppelt wird, wodurch das LC-Netzwerk entdämpft wird und die Güte steigt,
   - wobei die Induktivität (L) des LC-Netzwerkes durch einen Gyrator gebildet ist.

2. Schaltung nach Anspruch 1, **dadurch gekennzeichnet, dass** die Generatorfrequenz in Abhängigkeit von der Phasenlage variiert wird.

3. Schaltung nach Anspruch 2, **dadurch gekennzeichnet, dass** der Änderungsbedarf der Generatorfrequenz als Präsenzsignal ausgewertet wird.

### Claims

**1.** Circuit for detecting the presence, position and/or approach of an object in an observation area, with:

- a sensor electrode device which forms a part of a capacitor system, the capacitance of which depends, against a reference potential, on the presence, position or approach of objects in the observation area,
- a LC-network that comprises that capacitor system,
- an evaluation circuit coupled with the sensor electrode device, and
- a generator device for charging the system, formed by including the sensor electrode device and the LC-net, with a frequency in the range of a parallel resonance frequency of the LC network, in which
- the evaluation circuit is configured and structured in such a way that it detects an approach of an object to the sensor electrode device on the basis of a change of the resonance behaviour, and
- in which as change of the resonance behaviour the change of the phasing of a comparison signal of the LC network compared to a comparison signal from the area of the generator is detected,

**characterised in that**

- the tension applied at the LC network is re-coupled in phase by means of an operational amplifier (OPV) and a feedback capacitor (CR), by which the LC network is de-dampened, and the quality increased,
- wherein the inductance (L) of the LC network is formed by a gyrator.

**2.** Circuit according to claim 1, **characterised in that** the generator frequency is varied depending on the phasing.

**3.** Circuit according to claim 2, **characterised in that** the need for changes of the generator frequency is evaluated as a presence signal.

### Revendications

**1.** Circuit pour déterminer la présence, la position et/ou l'approche d'un objet dans un secteur d'observation, avec:

- un dispositif d'électrodes capteurs, qui forme une partie d'un système de condenseur, dont la capacité, contre un potentiel de référence, dépend de la présence, de la position ou de l'approche d'objets dans le secteur d'observation,
- on réseau LC, qui comprend ce système de condenseur,
- un circuit d'évaluation couplé avec le dispositif d'électrodes capteurs, et
- un dispositif générateur pour l'alimentation du système formé avec le dispositif d'électrodes capteurs et le réseau LC avec une fréquence dans la gamme d'une fréquence de résonance parallèle du réseau LC, où
- le circuit d'évaluation est configuré et structuré de façon à détecter l'approche d'un objet par rapport au dispositif d'électrodes capteurs sur la base d'un changement du comportement de résonance, et
- où, comme changement du comportement de résonance, la variation de la phase d'un signal de comparaison du réseau LC est relevée par rapport à un signal de comparaison de la zone du générateur,

**caractérisé en ce que**

- la tension au réseau LC est recouplée en phase au moyen d'un amplificateur opérationnel (OPV) et d'un condenseur de réaction (CR),

de sorte que le réseau LC est égalisé, et la qualité augmente,

- où l'inductance (en L) du réseau LC est formée par un gyrateur.

**2.** Circuit selon la revendication 1, **caractérisé en ce que** la fréquence du générateur varie en fonction de la phase.

**3.** Circuit selon la revendication 2, **caractérisé en ce que** le besoin de changement de la fréquence du générateur est évalué comme signal de présence.

# Kapazitiver Sensor

**Elektrode**

**Gen.** C1 C2 **Auswert-ung**

**Fig.1a**

**Elektrode**

**Gen.** C1 $C_k$ K C2 **Auswert-ung**

**Elektrode**

$C_g$

**Fig.1b**

EP 1 943 734 B1

Kapazitiver Sensor

Fig. 2b

Fig. 2a

## Kapazitiver Sensor mit Shield

Fig.3

EP 1 943 734 B1

# Phasenvariation durch Kapazitätsänderung

Fig.4

# Auswerteelektronik für kapazitiven Sensor mit Phasenverfahren

Fig.5

Anordnung zur kapazitiven Positionsbestimmung in einem Feld mittels Phasenverfahren

Fig.6

EP 1 943 734 B1

# Linearisierung der Phasendifferenz zwischen einem Elektrodenpaar

### Phasendifferenz

Fig.7a

### Phasensumme

Fig.7b

Elektrodenstruktur zur Positionsbestimmung

Aktive Felder für Touch

Fig.8

Touchfeld-Elektronik

Fig.9

# Sensorik an Fensterheber

Sensordraht

L    C

Stellmechanismus

Auswertung

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• US 3103655 A